Europäisches Patentamt

European Patent Office

Office européen des brevets

(19)

(11) Veröffentlichungsnummer: **0 195 299**
**B1**

(12) # EUROPÄISCHE PATENTSCHRIFT

(45) Veröffentlichungstag der Patentschrift: **05.12.90**

(21) Anmeldenummer: **86102756.3**

(22) Anmeldetag: **03.03.86**

(51) Int. Cl.⁵: **H 03 B 21/02**, H 03 F 3/45

(54) **Dynamischer Frequenzteiler mit Mischstufe und Verstärker.**

(30) Priorität: **15.03.85 DE 3509327**

(43) Veröffentlichungstag der Anmeldung:
**24.09.86 Patentblatt 86/39**

(45) Bekanntmachung des Hinweises auf die
Patenterteilung:
**05.12.90 Patentblatt 90/49**

(84) Benannte Vertragsstaaten:
**FR GB IT NL SE**

(56) Entgegenhaltungen:
DE-A-2 720 614
GB-A-1 111 571

PHILIPS TECHNICAL REVIEW, Band 38, Nr. 2,
1978/79, Seiten 54-68, Eindhoven, NL; W.D.
KASPERKOVITZ: "Frequency-dividers for ultrahigh frequencies"

ELECTRONICS LETTERS, Band 15, Nr. 20,
September 1979, Seiten 650-652, Hitchin, GB; K.
OGAWA et al.: "GaAs F.E.T. transimpedance
front-end design for a wideband optical
receiver"

(73) Patentinhaber: **TELEFUNKEN electronic GmbH**
**Theresienstrasse 2**
**D-7100 Heilbronn (DE)**

(72) Erfinder: **Rein, Hans-Martin, Prof.-Dr.**
**Ein Bäumchen 6**
**D-5810 Witten 3 (DE)**

(74) Vertreter: **Maute, Hans-Jürgen, Dipl.-Ing.**
**TELEFUNKEN electronic GmbH**
**Theresienstrasse 2**
**D-7100 Heilbronn (DE)**

(56) Entgegenhaltungen:
**IBM TECHNICAL DISCLOSURE BULLETIN, Band**
**27, Nr. 4B, September 1984, Seiten 2521,2522,**
**New York, US; D.L. ROGERS: "Transimpedance**
**input stage for current amplifiers"**

# Beschreibung

Zur Teilung hoher Frequenzen werden heute neben statischen Teilern sogenannte dynamische Frequenzteiler verwendet. Ein dynamischer Frequenzteiler ist beispielsweise in der Zeitschrift "Philips technische Rundschau" 38, Nr. 2, 1979, Seite 47—62, insbesondere Seite 59 beschrieben. Dieser dynamische Frequenzteiler weist eine Mischstufe auf, die zur Mischung von Signalen dient, deren Frequenzen sich um den Faktor 2 unterscheiden. Das Ausgangssignal des Mischers wird durch einen Verstärker verstärkt, der nur die Grundfrequenz des Ausgangssignals verstärkt. Dies erreicht man durch einen Verstärker mit Tiefpaßwirkung oder durch einen Verstärker mit nachgeschaltetem Tiefpaßfilter. Das verstärkte Signal mit der Grundfrequenz wird auf die Mischstufe zurückgekoppelt, so daß ein geschlossener Kreis ensteht.

Der Erfindung liegt die Aufgabe zugrunde, einen monolithisch integrierbaren dynamischen Frequenzteiler fach dem oben beschriebenen Grundkonzept anzugeben, der so ausgeführt ist, daß die maximale Betriebsfrequenz (fmax) möglich hoch und der zulässige Frequenzbereich möglich breit wird (fmax/fmin groß), und daß außerdem in gesamten Frequenzbereich (fmin ≤ f ≤ fmax) ein stabiler Betrieb möglich ist. Diese Forderungen lassen sich besonders gut erfüllen, wenn der Frequenzgang der Ringverstärkung des gesamten Frequenzteilers (Mischer+Verstärker) weitgehend dem eines idealen Verstärkers mit nachgeschaltetem idealem Tiefpaß hoher Grenzfrequenz entspricht.

Die der Erfindung zugrundeliegende Aufgabe wird bei einen dynamischen Frequenzteiler mit Mischstufe und nachgeschaltetem Verstärker, dessen Ausgang auf einen Eingang des Mischstufe zurückgekoppelt ist, nach der Erfindung dadurch gelöst, daß die Mischstufe eine transistorisierte Mischstufe ist, daß der Verstärker ein Transimpedanz-Verstärker ist oder sich wie ein solcher verhält und daß der Verstärker so ausgebildet ist, daß er den Verstärkungsabfall der Mischstufe bis zu hohen Frequenzen möglichst weitgehend ausgleicht.

Ein Transimpedanz-Verstärker hat bekanntlich eine kleine Ausgangsimpedanz und eine kleine Eingangsimpedanz bis hin zu hohen Frequenzen bei hoher Bandreite der durch den Quotienten aus Ausgangsspannung und Eingangsstrom definierten Übertragungsfunktion.

Die kleinen Werte der Ein- und Ausgangsimpedanz sorgen für eine hohe maximale Betriebsfrequenz wegen der schnellen Umladung parasitärer Kapazitäten . Eine Anhebung der Verstärkung bei hohen Frequenzen kompensiert den Verstärkungsabfall in der restlichen Schaltung (Mischer u. a.), wodurch die maximale Betriebsfrequenz weiter erhöht wird. Außerdem wird hierdurch, zusammen mit dem steilen Abfall der Verstärkung, ein Frequenzgang der gesamten Schaltung erreicht, der den eines idealen Tiefpasses gut annähert.

Der gewünschte Frequenzgang des Verstärkers **wird in optimaler Weise dadurch erreicht, daß** eine induktive Komponente der Verstärkerausgangsimpedanz zusammen mit einer am Ausgang angreifenden kapazitiven Latkomponente eine Art Resonanzeffekt erzeugt. Ein solcher Resonanzeffekt kann verstärkt auftreten, wenn die Lastimpedanz oder die Ausgangsimpedanz des Verstärkers bei hohen Frequenzen einen negativen Reilteil aufweist.

Die induktive Komponente der Ausgangsimpedanz kann auf einfache Weise durch geeignete Dimensionierung (z.B. über den Gegenkopplungswiderstand) der Transimpedanzstufe und/ oder durch nachgeschaltete Emitterfolger erzielt werden. Letztere können u.U. auch für einen negativen Realteil bei hohen Frequenzen sorgen. Für die gewünschte kapazitive Komponente der Last sorgt die Impedanz des Mischereingangs. Werden dem Mischer Emitterfolger vergeschaltet, so wird dadurch die gewünschte kapazitive Komponente der Last verstärkt und gleichzeitig in gewünschter Weise bei hohen Frequenzen ein negativer Realteil erzielt. Die zur Verbesserung des Frequenzganges zwischen dem Ausgang der Transimpedanzstufe und dem Eingang der Mischstufe geschalteten Emitterfolger dienen auch zur Entkopplung von Verstärkerausgang und Mischereingang und erhöhen damit weiter die maximale Betriebsfrequenz. Ferner sind sie in monolithisch integrierten Schaltungen (Gleichstromkopplung) zur Pegelverschiebung erforderlich. Auch die Verwendung eines Differenzverstärkers ist wegen der in monolithisch integrierten Schaltungen vorliegenden Gleichstromkopplung und wegen der höheren erreichbaren Bandbreite zweckmäßig.

Die Erfindung wird im folgenden an einem Ausführungsbeispiel erläutert.

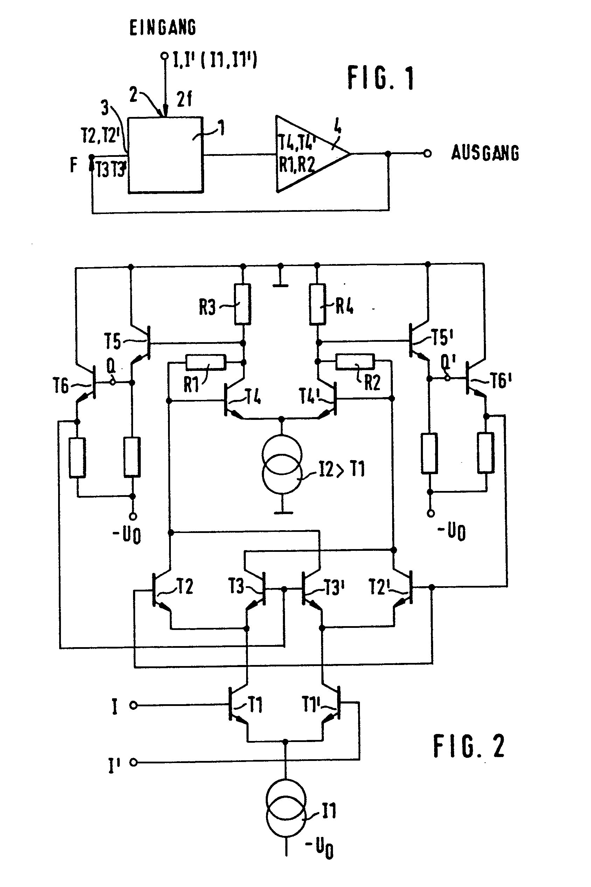

Die Figur 1 zeigt das Prinzipschaltbild eines dynamischen Frequenzteilers nach der Erfindung. Nach der Figur 1 besteht der Frequenzteiler aus einem Gegentaktmischer 1 mit einem ersten Eingang 2 und einem zweiten Eingang 3 sowie aus einem Verstärker 4. Der Verstärker 4 ist ein Transimpedanz-Verstärker. Ein Transimpedanz-Verstärker ist ein Verstärker, bei dem der Quotient aus Ausgangsleerlaufspannung und Eingangsstrom im wesentlichen durch einen Widerstand zwischen Ein- und Ausgang der Verstärkers bestimmt wird und der außerdem eine kleine Ein- und Ausgangsimpedanz besitzt. Im Falle einer einfachen Transistorstufe in Emitterschaltung liegt dieser Widerstand zwischen der Basis und dem Kollektor des Verstärkertransistors. Der Ausgang des Transimpedanz-Verstärkers 4 ist auf den zweiten Eingang 3 des Gegentakt-Mischers 1 zurückgekoppelt. Durch die Rückkopplung entsteht ein geschlossener Kreiz bzw. eine geschlossene Schleife.

Wird auf den ersten Eingang 2 des Gegentakt-Mischers 1 ein Signal mit der Frequenz 2f und auf seinen zweiten Eingang 3 ein Signal mit der Frequenz f gegeben, so entstehen am Ausgang des Mischers 1 Mischprodukte mit den Frequenzen f (Grundharmonische), 3f usw. (Oberwellen). Verstärkt man das Ausgangssignal des Mischers 1 mit den Frequenzen f, 3f usw. mittels des Verstärkers 4, der Tiefpaßwirkung hat und vom Ausgangssignal des Mischers 1 nur den Signalteil mit der Frequenz f verstärkt, so bleibt am Ausgang des Verstärkers 4 nur ein Signal mit der angestrebten geteilten Frequenz f, welches auf den zweiten Eingang 3 des Mischers 1 zurückgekoppelt wird. Das für die Mischung bzw. die Teilung erforderliche Signal mit der Grundfrequenz f, welches dem Mischer 1 außer der Frequenz 2f zugeführt werden muß, muß beim dynamischen Frequenzteiler der Figur 1 also nicht gesondert erzeugt werden, sondern es entsteht im geschlossenen Kreis als Mischprodukt.

Die Figur 2 zeigt die Schaltung der Figur 1 im einzelnen. Der Mischer des Frequenzteilers wird durch die Transistoren T1, T1', T2, T2', T3, T3' und die Stromquelle I1 gebildet. Die Transistoren T1 und T1' bilden einen Differenzverstärker. Die Transistoren T2 und T3 sind ebenso wie die Transistoren T2' und T3' emitterseitig miteinander verbunden. Der Kollektor des Transistors T1 ist mit der gemeinsamen Emitterleitung der Transistoren T2 und T3 und der Kollektor des Transistor T1' mit der gemeinsamen Emitterleitung der Transistoren T2' und T3' verbunden. Außerdem besteht eine Verbindung zwischen den Killektoren der Transistoren T2 und T3' einerseits und den Kollektoren der Transistoren T2' und T3 andererseits. Die Basis des Transistors T2 ist mit der Basis des Transistors T2' und die Basis des Transistors T3 ist mit der Basis des Transistors T3' verbunden.

Der Transimpedanz-Verstärker ist im Ausführungsbeispiel der Figur 2 ein Differenzverstärker. Gemäß der Figur 2 besteht der Verstärker aus den Transistoren T4 und T4', der Stromquelle I2 und den Widerständen R1 und R2. Nach der Figur 2 ist ein Widerstand R1 zwischen die Basis und den Kollektor des Transistors T4 und ein Widerstand R2 zwischen die Basis und den Kollektor des Transistors T4' geschaltet. Die Widerstände R1 und R2 haben im allgemeinen gleiche Werte. Die Kollektoren der Transistoren T4 und T4' sind jeweils über einen Widerstand (R3, R4) mit dem Bezugspotential verbunden. Über die gemeinsame Emitterleitung der Transistoren T4 und T4' wird mittels der Stromquelle I2 ein Strom in den Transimpedanz-Verstärker eingespeist. Dieser Strom ist größer als derjenige Strom, den die Stromquelle I1 in den Mischer einspeist.

Zur Optimierung des Frequenzgangs, zur Entkopplung und zur Pegelverschiebung sind je zwei Emitterfolger (Darlington-Stufe) vorgesehen, von denen die einen die Transistoren T5 und T6 und die anderen die Transistoren T5' und T6' aufweisen. In den Emitterzuleitungen dieser Transistoren befinden sich Emittervorwiderstände, die in der Figur 2 nicht bezeichnet sind.

Der Eingang des Mischers wird durch die Anschlußpunkte I und I' gebildet. Diesem Eingang wird ein Signal mit der Frequenz 2f zugeführt. Die Punkte Q und Q' bilden einen interen Ausgang des Frequenzteilers, an dem ein Signal mit der Frequenz f zur Verfügung steht.

Der Frequenzteiler der Figur 2 funktioniert wie folgt. Auf den Eingang (I, I') des Mischers wird ein Signal mit der zu teilenden Frequenz 2f gegeben. Durch den Mischer fließt der eingeprägte Strom I1. Durch Mischung des Signals mit der Frequenz 2f mit einem Signal der Frequenz f, das an die Transistoren T2 und T2' einerseits und an die Transistoren T3 und T3' andererseits angelegt wird, entstehen am Ausgang des Mischers (Kollektor T2, T3' bzw. Kollektor T3, T2') Mischprodukte mit den Frequenzen f (Grundharmonische), 3f usw. (Oberwellen).

Verstärkt man das Ausgangssignal (Mischprodukte) des Mischers mit einem Verstärker mit Tiefpaßwirkung, der wie der Verstärker der Figur 2 die Eigenschaft hat, daß er vom Ausgangssignal nur den Anteil mit der Frequenz f verstärkt, die anderen Anteile (3f usw.) dagegen unterdrückt, so gelangt zum Ausgang des Mischers nur ein Signal, welches die gewünschte Frequenz f aufweist. Dieses Signal wird über eine Rückkoppelschaltung, die aus den Emitterfolgern mit den Transistoren T5, T6 und T5', T6' besteht, auf die Transistoren T3, T3' bzw. T2, T2' des Mischers zurückgekoppelt. In der Anschwingphase des Frequenz-Teilungsprozesses erhält man die benötigte Frequenz f z. P. aus dem Rauschen.

Der Frequenzteiler der Erfindung und damit auch der Frequenzteiler der Figur 2 kann sehr hohe Frequenzen teilen, weil sein Verstärker nach der Erfindung ein sogenannter Transimpedanz-Verstärker ist, der aus den Transistoren T4 und T4' besteht und bei dem zwischen die Basen und die Kollektoren der Transistoren T4 und T4' jeweils ein Widerstand (R1, R2) geschaltet ist. Der Verstärker arbeitet mit dem Strom I2, der größer als der Mischerstrom I1 sein muß.

Das Ausführungsbeispiel zeigt, mit welchem geringen Aufwand an Bauelementen sich ein solcher Transimpedanz-Verstärker mit Entkopplungsstufe realisieren läßt und wie einfact er monolithisch integriert werden kann. Ferner ist der geringe Leistungsverbrauch hervorzuheben.

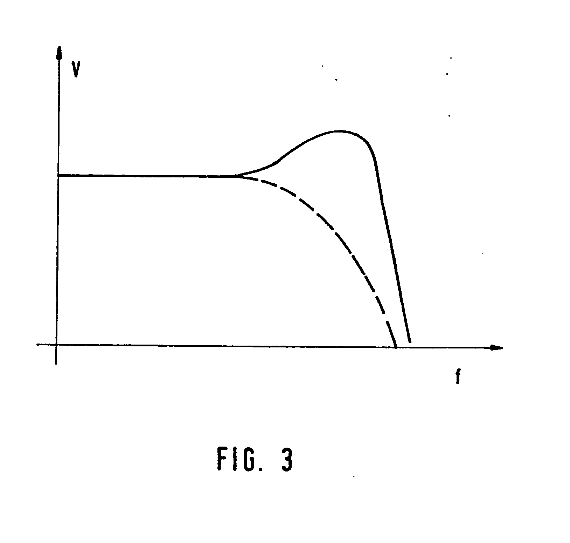

Für die Erfindung ist wesentlich, daß der Verstärker des Frequenzteilers durch die Gegenkopplung (R1, R2) eine kleine Ein- und Ausgangsimpedanz bei hoher Bandbreite der Übertragungsfunktion aufweist und daß die Gegenkopplung außerdem zu einer induktiven Komponente der Ausgangsimpedanz führt. Durch anschließende Emitterfolger läßt sich die induktive Komponente verstärken und u. U. sogar ein negativer Reilteil erzielen. Diese Ausgangsimpedanz sorgt bei Vorliegen einer Lastimpedanz mit kapazitiver Komponente und u. U. negativem Realteil (die beim Frequenzteiler nach der Erfindung beispielsweise durch Emitterfolger bzw. Darlington-Stufen realisiert wird) dafür, daß der Verstärker gemäß Fig. 3 eine Anhebung der Verstärker bei hohen Frequenzen mit anschließend steilem Verstärkungsabfall aufweist.

Mit der Verstärkungsanhebung gekoppelt ist beim Frequenzteiler nach der Erfindung gemäß der Figur 3 ein anschließend starker Verstärkungsabfall, der wunschgemäß für eine sehr gutes Tiefpaßverhalten des gesamten Frequenzteilers zur Ausfilterung der unerwünschten Frequenzen (Harmonische 3f usw.) sorgt.

Die gewünschten Verstärkereigenschaften werden beim Frequenzteiler nach der Erfindung durch die Verwendung eines Transimpedanz-Verstärkers anstelle eines normalen Verstärkers erzielt. Ein Transimpedanz-Verstärker unterscheidet sich — in seiner einfachsten Ausführung — von einem einfachen normalen Verstärker dadurch, daß beim Verstärkertransistor (T4, T4') zwischen die Basis und den Kollektor ein ohmscher Widerstand (R1, R2) geschaltet ist, der eine Gegenkopplung verursacht. Dieser Widerstand ist so zu bemessen, daß Ringsverstärkung und Bandbreite ausreichend hoch sind und daß die Verstärkungskurve gemäß der Figur 3 bei hohen Frequenzen eine Anhebung in Verbindung mit einem steilen Abfall aufweist.

## Patentansprüche

1. Dynamischer Frequenzteiler mit Mischstufe und nachgeschaltetem Verstärker, dessen Ausgang auf einen Eingang der Mischstufe zurückgekoppelt ist, dadurch gekennzeichnet, daß die Mischstufe ein transistorisierte Mischstufe ist, daß der Verstärker ein Transimpedanz-Verstärker ist oder sich wie ein solcher verhält und daß der Verstärker so ausgebildet ist, daß er den Verstärkungsabfall der Mischstufe bis zu hohen Frequenzen möglichst weitgehend ausgleicht.

2. Frequenzteiler nach Anspruch 1, dadurch gekennzeichnet, daß sich am Verstärkerausgang Emitterfolger oder Darlington-Stufen befinden, die zur Optimierung des Frequenzgangs, zur Impedanzwandlung und zur Pegelverschiebung dienen.

3. Frequenzteiler nach Anspruch 1 oder 2, dadurch gekennzeichnet, daß der Verstärker derart ausgebildet ist, daß er eine kleine Ausgangsimpedanz und eine kleine Eingangsimpedanz sowie eine hohe Bandbreite der Übertragungsfunktion aufweist.

4. Frequenzteiler nach einem der Ansprüche 1 bis 3, dadurch gekennzeichnet, daß der Verstärker so ausgebildet ist, daß er eine Anhebung der Verstärker bei hohen Frequenzen mit anschließend steilem Abfall der Verstärkung aufweist.

5. Frequenzteiler nach einem der Ansprüche 1 bis 4, dadurch gekennzeichnet, daß der Verstärker eine Ausgangsimpedanz mit induktiver Komponente aufweist.

6. Frequenzteiler nach einem der Ansprüche 1 bis 5, dadurch gekennzeichnet, daß am Ausgang des Verstärkers eine Last mit kapazitiver Komponente und/oder negativem Realteil auftritt.

7. Frequenzteiler nach einem der Ansprüche 1 bis 6 dadurch gekennzeichnet, daß der Verstärker ein Differenzverstärker ist.

## Revendications

1. Diviseur de fréquence dynamique avec étage mélangeur suivi d'un amplificateur, dont la sortie est rétrocouplée à une entrée de l'étage mélangeur, caractérisé par le fait que l'étage mélangeur est une étage mélanger transistorisé, par le fait que l'amplificateur est un amplificateur à transimpédance ou se comporte comme un tel amplificateur, et par le fait que l'amplificateur est constitué de manière à compenser aussi substantiellement que possible la décroissance d'amplification de l'étage mélangeur, jusqu'aux fréquences élevées.

2. Diviseur de fréquence selon revendication 1, caractérisé par le fait que des émetteurs-suiveurs ou étages Darlington se trouvent à la sortie de l'amplificateur et servent à l'optimisation de la caractéristique fréquentielle, à la conversion s'impédance et au déplacement de niveau.

3. Diviseur de fréquence selon revendication 1 ou 2, caractérisé par le fait que l'amplificateur est conçu et réalisé de manière à présenter une petite impédance de sortie et une petite impédance d'entrée, ainsi qu'une grande largeur de bande de la fonction de transfert.

4. Diviseur de fréquence selon l'une des revendications 1 à 3, caractérisé par le fait que l'amplificateur est conçu et réalisé de manière à présenter un accroissement de l'amplification aux fréquences élevées, suivi d'une décroissance rapide de l'amplification.

5. Diviseur de fréquence selon l'une des revendications 1 à 4, caractérisé par le fait que l'amplificateur présente une impédance de sortie avec composante inductive.

6. Diviseur de fréquence selon l'une des revendications 1 à 5, caractérisé par le fait au'une charge avec composante capacitive et/ou partie réelle négative apparaît à la sortie de l'amplificateur.

7. Diviseur de fréquence selon l'une des revendications 1 à 6, caractérisé par le fait que l'amplificateur est un amplificateur différentiel.

## Claims

1. A dynamic frequency divider with mixer stage and following amplifier, the output of which is fed back to an input of the mixer stage, characterised in that the mixer stage is a transistorized mixer stage that the amplifier is a transimpedance amplifier or behaves like one, and that the amplifier is so constructed that it compensates as far as possible for the loss of gain of the mixer stage up to high frequencies.

2. A frequency divider according to Claim 1, characterised in that at the amplifier output there are emitter followers or Darlington stages which serve to optimize the frequency response, to transform the impedance and to shift the level.

3. A frequency divider according to Claim 1 or 2, characterised in that the amplifier is constructed in such a manner that it has a low output impedance and a low input impedance as well as a high bandwidth of the transfer function.

4. A frequency divider according to any one of Claims 1 to 3, characterised in that the amplifier is so constructed that it accentuates the gain at high frequencies with a following steep drop in the gain.

5. A frequency divider according to any one of Claims 1 to 4, characterised in that the amplifier has an output impedance with inductive components.

6. A frequency divider according to any one of Claims 1 to 5, characterised in that a load with capacitive components and/or a negative real component appears at the output of the amplifier.

7. A frequency divider according to any one of Claims 1 to 6, characterised in that the amplifier is a differential amplifier.

EINGANG

1,1' ( I1,I1')

FIG. 1

AUSGANG

FIG. 2

FIG. 3